(19) **Europäisches Patentamt / European Patent Office / Office européen des brevets**

(11) **EP 3 822 868 A1**

(12) # EUROPEAN PATENT APPLICATION
published in accordance with Art. 153(4) EPC

(43) Date of publication:
**19.05.2021 Bulletin 2021/20**

(21) Application number: **19875735.3**

(22) Date of filing: **25.09.2019**

(51) Int Cl.:
***G06N 7/00*** *(2006.01)*

(86) International application number:
**PCT/CN2019/107944**

(87) International publication number:
**WO 2020/082972 (30.04.2020 Gazette 2020/18)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(30) Priority: **22.10.2018 CN 201811227347**

(71) Applicant: **Ennew Digital Technology Co., Ltd.**
**Langfang, Hebei 065001 (CN)**

(72) Inventor: **YANG, Jie**
**Langfang, Hebei 065001 (CN)**

(74) Representative: **Petculescu, Ana-Maria**
**Bayramoglu Law Offices LLC Türkiye**
**Irtibat Ofisi, Mira Office, Kanuni Sultan**
**Süleyman Boulevard, 5387. street**
**Beytepe, floor 12, no:50**
**06800 Cankaya, Ankara (TR)**

(54) **METHOD AND APPARATUS FOR MONITORING OPERATING DATA OF BOILER BASED ON BAYESIAN NETWORK**

(57) A method and apparatus for monitoring operating data of a boiler system based on a Bayesian network. The method comprises: S1: establishing a boiler system state model according to association relationships between various components of a boiler system and different positions of the components; S2: collecting operating states of the components and of the components at the different positions by means of a sensor, so as to obtain a boiler system observation model; S3: obtaining a boiler system model, combining the boiler system state model and the boiler system observation model; and S4: according to the boiler system model, inferring missing observation data and determining whether the observation data is abnormal. The method and apparatus construct a device-operating model based on a Bayesian network, monitor the correctness of data by means of the model, and completely supply missing data, thereby providing convenience for subsequent device remote diagnosis.

FIG. 1

**Description**

**TECHNICAL FIELD**

The present disclosure relates to the field of data processing technologies, and in particular, to a method and apparatus for monitoring operating data of a boiler based on a Bayesian network.

**BACKGROUND**

In industrial production sites, a large amount of data can be collected through a sensor during operation of industrial equipment, and a working state of the equipment can be determined through the data. For example, temperature, pressure, and other data can be collected through a sensor during operation of a boiler, and a working state of the boiler can be determined through the data.

However, in an actual scenario, data collection is often partially missing or inaccurate due to various reasons, and corresponding completion or detection measures cannot be taken for partially missing or incorrect data, such as sensor reasons and problems in IOT data transmission. This would make it inconvenient for devices that rely on IOT data to diagnose remotely.

SUMMARY

Embodiments of the present disclosure provide a method and apparatus for monitoring operating data of a boiler based on a Bayesian network, which construct a device-operating model based on a Bayesian network, monitor the correctness of data by means of the model, and completely supply missing data, thereby providing convenience for subsequent device remote diagnosis.

In a first aspect, an embodiment of the present disclosure provides a method for monitoring operating data of a boiler based on a Bayesian network, the method including:

S1: establishing a boiler system state model according to association relationships between various components of a boiler system and different positions of the components;

S2: collecting operating states of the components and of the components at the different positions by means of a sensor, so as to obtain a boiler system observation model;

S3: obtaining a boiler system model by combining the boiler system state model and the boiler system observation model; and

S4: according to the boiler system model, inferring missing observation data and determining whether the observation data is abnormal.

For the problem of lack of observation data, from the perspective of the system, if most of the data can be correctly observed only part of the observation data is missing, this makes it possible to infer missing data from the observation data, because both the missing data and the observation data are a part of the overall system state and there is some correlation between them (such as steam outlet temperature and inlet temperature). It is assumed that $\hat{x}$ denotes missing data or incomplete observation data, $\tilde{x}$ denotes data that can be completely observed, $z_{1:n}$ denotes a system state variable, probability distribution $P(\hat{x}|\tilde{x}, z_{1:n})$ of $\hat{x}$ can be calculated based on the system model, an expected value $E[\hat{x}]$ of $\hat{x}$ is further calculated, and data completion is performed using the expected value as an estimated value of the missing data or incomplete observation data.

For the problem of abnormal data, the system model may deduce correctness of the data according to consistency in states of parts of the system and give warning to error data or further modify an error automatically. It is assumed that the observed value of the sensor at a certain moment is $x_{1:n}^{*}$, an observation probability $P(x_{1:n}^{*})$ can be calculated according to the system model, and $P(x_{1:n}^{*})$ can be used to determine whether the observation is abnormal (the possibility of being abnormal under a low observation probability is generally considered to be large), and the abnormal data can be corrected under certain circumstances.

Preferably, overall state distribution of the boiler system state model in S1 is expressed by the formula as follows:

$$P(z_{1:n}) = P(z_1)P(z_2|z_1) \cdots P(z_n|z_{1:n-1})$$

where $z_{1:n}$ is a collection of different components in the boiler system; and $z_n$ is the state of the nth component in the boiler system.

Preferably, in the boiler system state model, a relationship between the input $z_{n-1}$ and the output $z_n$ is:

$$z_n = F(z_{n-1}) + u$$

where F is a function of the system state model; $u$ is noise of the system state model, which conforms to Gaussian distribution.

Preferably, in the boiler system state model, conditional probability distribution between the input $z_{n-1}$ and the output $z_n$ is:

$$P(z_n|z_{n-1}) = N(F(z_{n-1}), \Sigma)$$

where $N(F(z_{n-1}), \Sigma)$ denotes Gaussian distribution.

Preferably, the boiler system observation model in S2 is expressed as:

$$P(x|z) = N(H(z), \sigma^2)$$

where P($x|z$) is probability distribution of measurements under the state z; $x$ denotes an observed value of the sensor; H is a function of the system observation model; and N($H(z)$, $\sigma^2$) denotes Gaussian distribution.

Preferably, the observed value of the sensor and the function of the system observation model satisfy the formula:

$$x = H(z) + \varepsilon$$

where $\varepsilon$ is noise of the observation model, which conforms to Gaussian distribution.

Preferably, the boiler system model in S3 is expressed by the formula as follows:

$$P(z_{1:n}, x_{1:n}) = P(z_1) P(z_2|z_1) \cdots P(z_n|z_{1:n-1})P(x_2|z_1) \cdots P(x_n|z_n)$$

where P($z_{1:n}$, $x_{1:n}$) is joint probability distribution of states and measurements.

In a second aspect, an embodiment of the present disclosure provides an apparatus for monitoring operating data of a boiler based on a Bayesian network, wherein the apparatus includes: a state module, an observation module, an integration module, and a monitoring module, wherein

the state module is configured to establish a boiler system state model according to association relationships between various components of a boiler system and different positions of the components;

the observation module is configured to collect operating states of the components and of the components at the different positions by means of a sensor, so as to obtain a boiler system observation model;

the integration module is configured to obtain a boiler system model by combining the boiler system state model established by the state module and the boiler system observation model obtained by the observation module; and

the monitoring module is configured to, according to the boiler system model, infer missing observation data and determine whether the observation data is abnormal.

Preferably, overall state distribution of the boiler system state model established by the state module is expressed by the formula as follows:

$$P(z_{1:n}) = P(z_1)P(z_2|z_1) \cdots P(z_n|z_{1:n-1})$$

where $z_{1:n}$ is a collection of different components in the boiler system; and $z_n$ is the state of the nth component in the boiler system.

Preferably, in the boiler system state model, a relationship between the input $z_{n-1}$ and the output $z_n$ is:

$$z_n = F(z_{n-1}) + u$$

where F is a function of the system state model; u is noise of the system state model, which conforms to Gaussian distribution.

Preferably, in the boiler system state model, conditional probability distribution between the input $z_{n-1}$ and the output $z_n$ is:

$$P(z_n | z_{n-1}) = N(F(z_{n-1}), \Sigma)$$

where $N(F(z_{n-1}), \Sigma)$ denotes Gaussian distribution.

Preferably, the boiler system observation model obtained by the observation module is expressed as:

$$P(x|z) = N(H(z), \sigma^2)$$

where $P(x|z)$ is probability distribution of measurements under the state z; x denotes an observed value of the sensor; H is a function of the system observation model; and $N(H(z), \sigma^2)$ denotes Gaussian distribution.

Preferably, the observed value of the sensor and the function of the system observation model satisfy the formula:

$$x = H(z) + \varepsilon$$

where $\varepsilon$ is noise of the observation model, which conforms to Gaussian distribution.

Preferably, the boiler system model obtained by the integration module is expressed by the formula as follows:

$$P(z_{1:n}, x_{1:n}) = P(z_1) P(z_2|z_1) \cdots P(z_n|z_{1:n-1}) P(x_2|z_1) \cdots P(x_n|z_n)$$

where $P(z_{1:n}, x_{1:n})$ is joint probability distribution of states and measurements.

Compared with the prior art, the present disclosure has at least the following beneficial effects:

From the perspective of a system, a statistical model of operating data of the system is constructed by taking the physical law of the system as prior knowledge and combining with sensor observation, and quality improvement and anomaly detection of the data are implemented based on the model.

**BRIEF DESCRIPTION OF THE DRAWINGS**

In order to more clearly illustrate technical solutions in embodiments of the present disclosure or the prior art, the accompanying drawings used in the embodiments or the prior art are briefly introduced as follows. Apparently, the drawings described as follows are merely part of the embodiments of the present disclosure, and other drawings can also be acquired by those of ordinary skill in the art without creative efforts.

FIG. 1 is a flowchart of a method for monitoring operating data of a boiler based on a Bayesian network according to an embodiment of the present disclosure;

FIG. 2 is a dependency diagram of a system model constructed based on a Bayesian network according to an embodiment of the present disclosure; and

FIG. 3 is a structural block diagram of a method for monitoring operating data of a boiler based on a Bayesian network according to an embodiment of the present disclosure.

**DETAILED DESCRIPTION OF THE EMBODIMENTS**

To make the objectives, technical solutions, and advantages of the embodiments of the present disclosure clearer, the technical solutions in the embodiments of the present disclosure will be described in detail as follows with reference to the accompanying drawings in the embodiments of the present disclosure. It is obvious that the embodiments to be described are only a part rather than all of the embodiments of the present disclosure. All other embodiments derived by those of ordinary skill in the art based on the embodiments of the present disclosure without creative efforts should fall within the protection scope of the present disclosure.

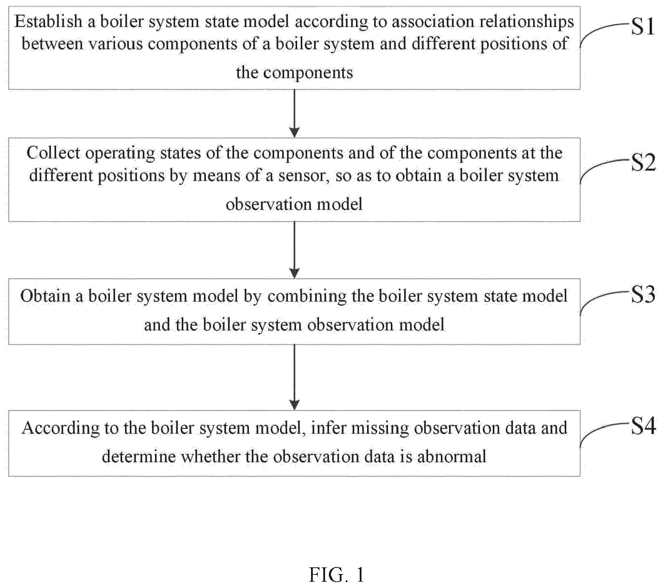

As shown in FIG. 1, an embodiment of the present disclosure provides a method for monitoring operating data of a boiler based on a Bayesian network. The method may include the following steps:

S1: Establish a boiler system state model according to association relationships between various components of a boiler system and different positions of the components.

S2: Collect operating states of the components and of the components at the different positions by means of a sensor, so as to obtain a boiler system observation model.

S3: Obtain a boiler system model by combining the boiler system state model and the boiler system observation model.

S4: According to the boiler system model, infer missing observation data and determine whether the observation data is abnormal.

In this embodiment, a statistical model of system operation is established according to the physical law of boiler system operation and a large amount of system operation data. Equipment IOT data is to collect physical states of various components of the equipment at different positions through a sensor. Firstly, the physical states of various components of the equipment at different positions are not independent of each other, and the states are related to each other according to physical laws. These states constitute input and output of different subsystems. A state is both the input of one subsystem and the output of another subsystem. Secondly, the observation of the state by the sensor is a system that is not completely reliable. When observation noise is introduced, there are problems such as missing observation, incomplete observation, and anomaly observation. can be solved by the overall modeling of the system. The problem of missing and inaccurate observation can be solved by overall modeling of the system.

In an embodiment of the present disclosure, overall state distribution of the boiler system state model in S1 is expressed by the formula as follows:

$$P(z_{1:n}) = P(z_1)P(z_2|z_1)\cdots P(z_n|z_{1:n-1})$$

where $z_{1:n}$ is a collection of different components in the boiler system; and $z_n$ is the state of the $n^{th}$ component in the boiler system.

In the boiler system state model, a relationship between the input $z_{n-1}$ and the output $z_n$ is:

$$z_n = F(z_{n-1}) + u$$

where F is a function of the system state model; u is noise of the system state model, which conforms to Gaussian distribution.

In the boiler system state model, conditional probability distribution between the input $z_{n-1}$ and the output $z_n$ is:

$$P(z_n|z_{n-1}) = N(F(z_{n-1}), \Sigma)$$

where $N(F(z_{n-1}), \Sigma)$ denotes Gaussian distribution.

In this embodiment, the system state model represents correlations between various states within the system and inputs and outputs of different subsystems. A state is both the input of one subsystem and the output of another subsystem. Subsystems that act as inputs can be called parent nodes, and subsystems that act as outputs can be called child nodes. The nodes depend on each other, and child nodes can be calculated from parent nodes thereof according to conditional probability distribution of the nodes based on the following formula:

$$z_n = F(z_{n-1}) + u$$

where $z_{n-1}$ is a parent node of $z_n$; F denotes a system model, which can be defined by business experts based on relevant knowledge in the art; u is noise of the system state model, which conforms to Gaussian distribution and may be expressed as $u \sim N(0, \Sigma)$.

At the same time, conditional probability distribution between the parent node $z_{n-1}$ and the child node $z_n$ is:

$$P(z_n|z_{n-1}) = N\big(F(z_{n-1}),\ \Sigma\big)$$

where $N(F(z_{n-1}),\Sigma)$ denotes Gaussian distribution.

Therefore, overall state distribution of the boiler system state model established by the state module is expressed by the formula as follows:

$$P(z_{1:n}) = P(z_1)P(z_2|z_1)\cdots P(z_n|z_{1:n-1})$$

where $z_{1:n}$ is a collection of different components in the boiler system; and $z_n$ is the state of the $n^{th}$ component in the boiler system.

In one embodiment of the present disclosure, the boiler system observation model in S2 is expressed as:

$$P(x|z) = N(H(z),\sigma^2)$$

where $P(x|z)$ is probability distribution of measurements under the state $z$; $x$ denotes an observed value of the sensor; $H$ is a function of the system observation model; and $N(H(z),\sigma^2)$ denotes Gaussian distribution.

The observed value of the sensor and the function of the system observation model satisfy the formula:

$$x = H(z) + \varepsilon$$

where $\varepsilon$ is noise of the observation model, which conforms to Gaussian distribution.

In this embodiment, system observation means observing an operating state of the system through a sensor, and the observation of the state by the sensor is a system that is not completely reliable. Observation noise is introduced herein, and the system observation model satisfies the following formula:

$$x = H(z) + \varepsilon$$

where $x$ denotes an observed value of the sensor; $H$ is a function of the system observation model; and $\varepsilon$ is noise of the observation model, which conforms to Gaussian distribution, and may be expressed as $\varepsilon - N(0, \sigma^2)$.

Thus, it can be obtained that the system observation model is expressed by the formula as follows:

$$P(x|z) = N\big(H(z),\ \sigma^2\big)$$

where $P(x|z)$ is probability distribution of measurements under the state $z$; and $N(H(z), \sigma^2)$ denotes Gaussian distribution.

In one embodiment of the present disclosure, the boiler system model in S3 is expressed by the formula as follows:

$$P(z_{1:n}, x_{1:n}) = P(z_1)\,P(z_2|z_1)\cdots P(z_n|z_{1:n-1})P(x_2|z_1)\cdots P(x_n|z_n)$$

where $P(z_{1:n}, x_{1:n})$ is joint probability distribution of states and measurements.

In this embodiment, the system model can be obtained by integrating the system state model and the system observation model, which may be expressed by the formula as follows:

$$P\big(z_{1:n},\ x_{1:n}\big) = P(z_1)\,P(z_2|z_1)\cdots P(z_n|z_{1:n-1})P(x_2|z_1)\cdots P(x_n|z_n)$$

It is worth noting that much valuable information can be obtained from the data through reasoning calculation on the system model, such as whether the observation data of the sensor is reasonable and whether the current system operation state is normal.

For a dynamic random system with incomplete observation, because the system has a plurality of associated states at the same time, it is an effective method to use a Bayesian network with hidden variables to model the system.

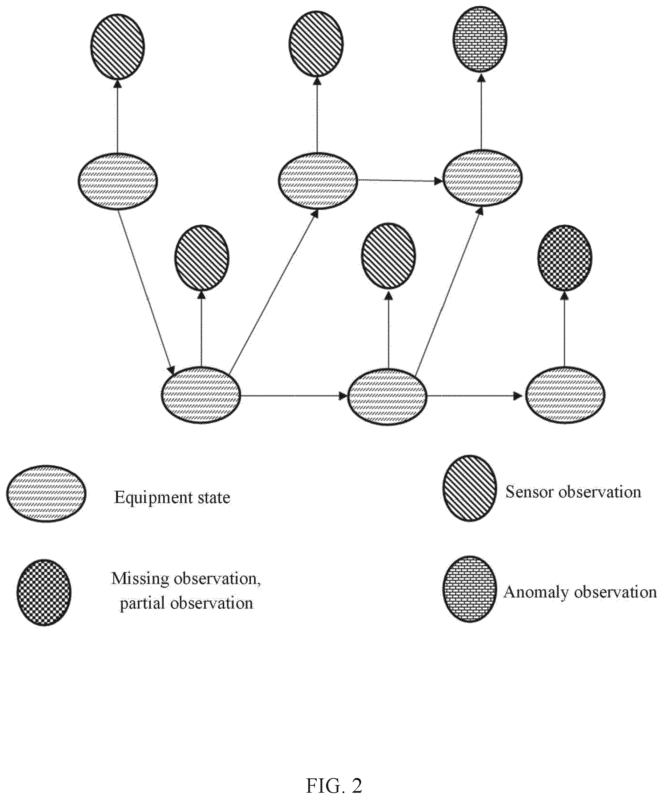

As shown in FIG. 2, a system model is briefly presented. The system model is composed of a plurality of states within the system and sensor observations corresponding to the states, and is represented by a directed acyclic graph. Four types of nodes are included in the figure, namely: nodes representing states of the system (unobservable hidden variables); nodes for sensor observations; missing or partial observation nodes; and anomaly observation node. Arrows in the figure represent interdependencies between the nodes, that is, relationships between the states of the system.

In one embodiment of the present disclosure, in step S4, according to the boiler system model, missing observation data is inferred and it is determined whether the observation data is abnormal. A system model can be trained and completed from system operation data. The system model reflects joint probability distribution of various states when the system is working. The normal working state of the system has a higher probability, and a plurality of data fault tolerance tasks can be completed according to the system model.

For the problem of lack of observation data, from the perspective of the system, if most of the data can be correctly observed only part of the observation data is missing, this makes it possible to infer missing data from the observation data, because both the missing data and the observation data are a part of the overall system state and there is some correlation between them (such as steam outlet temperature and inlet temperature). It is assumed that $\hat{x}$ denotes missing data or incomplete observation data, $\tilde{x}$ denotes data that can be completely observed, $z_{1:n}$ denotes a system state variable, probability distribution $P(\hat{x}|\tilde{x}, z_{1:n})$ of $\hat{x}$ can be calculated based on the system model, an expected value $E[\hat{x}]$ of $\hat{x}$ is further calculated, and data completion is performed using the expected value as an estimated value of the missing data or incomplete observation data.

For the problem of abnormal data, the system model may deduce correctness of the data according to consistency in states of parts of the system and give warning to error data or further modify an error automatically. It is assumed that the observed value of the sensor at a certain moment is $x_{1:n}^{*}$, an observation probability $P(x_{1:n}^{*})$ can be calculated according to the system model, and $P(x_{1:n}^{*})$ can be used to determine whether the observation is abnormal (the possibility of being abnormal under a low observation probability is generally considered to be large), and the abnormal data can be corrected under certain circumstances.

A device-operating model is constructed based on a Bayesian network, the correctness of data is monitored by the system model, and missing data is completely supplied, thereby providing convenience for subsequent device remote diagnosis.

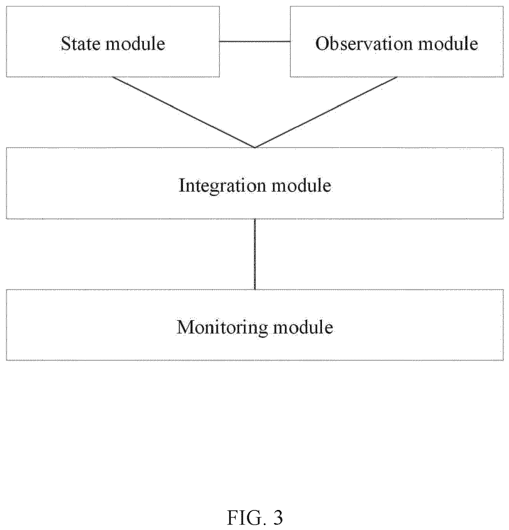

As shown in FIG. 3, an embodiment of the present disclosure provides a .... The method may include the following steps: An embodiment of the present disclosure provides an apparatus for monitoring operating data of a boiler based on a Bayesian network. The apparatus includes: a state module, an observation module, an integration module, and a monitoring module, wherein

the state module is configured to establish a boiler system state model according to association relationships between various components of a boiler system and different positions of the components;

the observation module is configured to collect operating states of the components and of the components at the different positions by means of a sensor, so as to obtain a boiler system observation model;

the integration module is configured to obtain a boiler system model by combining the boiler system state model established by the state module and the boiler system observation model obtained by the observation module; and

the monitoring module is configured to, according to the boiler system model, infer missing observation data and determine whether the observation data is abnormal.

In this embodiment, a statistical model of system operation is established according to the physical law of boiler system operation and a large amount of system operation data. Equipment IOT data is to collect physical states of various components of the equipment at different positions through a sensor. Firstly, the physical states of various components of the equipment at different positions are not independent of each other, and the states are related to each other according to physical laws. These states constitute input and output of different subsystems. A state is both the input of one subsystem and the output of another subsystem. Secondly, the observation of the state by the sensor is a system that is not completely reliable. When observation noise is introduced, there are problems such as missing observation, incomplete observation, and abnormal observation. can be solved by the overall modeling of the system. The problem of missing and inaccurate observation can be solved by overall modeling of the system.

The system state model represents correlations between various states within the system and inputs and outputs of different subsystems. A state is both the input of one subsystem and the output of another subsystem. Subsystems that act as inputs can be called parent nodes, and subsystems that act as outputs can be called child nodes. The nodes depend on each other, and child nodes can be calculated from parent nodes thereof according to conditional probability distribution of the nodes based on the following formula:

$$z_n = F(z_{n-1}) + u$$

where $z_{n-1}$ is a parent node of $z_n$; $F$ denotes a system model, which can be defined by business experts based on relevant knowledge in the art; $u$ is noise of the system state model, which conforms to Gaussian distribution and may be expressed as $u \sim N(0, \Sigma)$.

At the same time, conditional probability distribution between the parent node $z_{n-1}$ and the child node $z_n$ is:

$$P(z_n|z_{n-1}) = N\left(F(z_{n-1}), \ \Sigma\right)$$

where $N(F(z_{n-1}),\Sigma)$ denotes Gaussian distribution.

Therefore, overall state distribution of the boiler system state model established by the state module is expressed by the formula as follows:

$$P(z_{1:n}) = P(z_1)P(z_2|z_1) \cdots P(z_n|z_{1:n-1})$$

where $z_{1:n}$ is a collection of different components in the boiler system; and $z_n$ is the state of the $n^{th}$ component in the boiler system.

System observation means observing an operating state of the system through a sensor, and the observation of the state by the sensor is a system that is not completely reliable. Observation noise is introduced herein, and the system observation model satisfies the following formula:

$$x = H(z) + \varepsilon$$

where x denotes an observed value of the sensor; $H$ is a function of the system observation model; and $\varepsilon$ is noise of the observation model, which conforms to Gaussian distribution, and may be expressed as $\varepsilon \sim N(0, \sigma^2)$.

Thus, it can be obtained that the system observation model is expressed by the formula as follows:

$$P(x|z) = N\left(H(z), \ \sigma^2\right)$$

where $P(x|z)$ is probability distribution of measurements under the state z; and $N(H(z), \sigma^2)$ denotes Gaussian distribution.

Based on the above, the system model can be obtained by integrating the system state model and the system observation model, which is expressed by the formula as follows:

$$P(z_{1:n}, x_{1:n}) = \ P(z_1) \, P(z_2|z_1) \cdots P(z_n|z_{1:n-1})P(x_2|z_1) \cdots P(x_n|z_n)$$

It is worth noting that much valuable information can be obtained from the data through reasoning calculation on the system model, such as whether the observation data of the sensor is reasonable and whether the current system operation state is normal.

A system model can be trained and completed from system operation data. The system model reflects joint probability distribution of various states when the system is working. The normal working state of the system has a higher probability, and a plurality of data fault tolerance tasks can be completed according to the system model.

For the problem of lack of observation data, from the perspective of the system, if most of the data can be correctly observed only part of the observation data is missing, this makes it possible to infer missing data from the observation data, because both the missing data and the observation data are a part of the overall system state and there is some correlation between them (such as steam outlet temperature and inlet temperature). It is assumed that $\hat{x}$ denotes missing data or incomplete observation data, $\tilde{x}$ denotes data that can be completely observed, $z_{1:n}$ denotes a system state variable, probability distribution $P(\hat{x}|\tilde{x}, z_{1:n})$ of $\hat{x}$ can be calculated based on the system model, an expected value $E[\hat{x}]$ of $\hat{x}$ is further calculated, and data completion is performed using the expected value as an estimated value of the missing data or incomplete observation data.

For the problem of abnormal data, the system model may deduce correctness of the data according to consistency in states of parts of the system and give warning to error data or further modify an error automatically. It is assumed that the observed value of the sensor at a certain moment is $x_{1:n}^*$, an observation probability $P(x_{1:n}^*)$ can be calculated according to the system model, and $P(x_{1:n}^*)$ can be used to determine whether the observation is abnormal (the possibility of being abnormal under a low observation probability is generally considered to be large), and the abnormal data can be corrected under certain circumstances.

A device-operating model is constructed based on a Bayesian network, the correctness of data is monitored by the system model, and missing data is completely supplied, thereby providing convenience for subsequent device remote diagnosis.

Contents such as information exchange and execution process among the modules in the apparatus are based on the same conception as the embodiment of the method of the present disclosure. Specific contents can be obtained with reference to the description in the embodiment of the method of the present disclosure, and are not described in detail here.

It should be noted that, herein, the relation terms such as first and second are merely used to distinguish one entity or operation from another entity or operation, and do not require or imply that the entities or operations have this actual relation or order. Moreover, the terms "include," "comprise" or other variations thereof are intended to cover non-exclusive inclusion, so that a process, method, item or device including a series of elements not only includes the elements, but also includes other elements not clearly listed, or further includes elements inherent to the process, method, item or device. In the absence of more limitations, an element defined by the statement "including a/an..." does not exclude that the process, method, item or device including the element further has other identical elements.

Those of ordinary skill in the art should understand that all or a part of the steps of the method embodiment can be implemented by a program instructing relevant hardware. The program may be stored in a computer-readable storage medium. When the program is executed, the steps of the method embodiment are performed. The storage medium may be various media that can store program code, such as a ROM, a RAM, a magnetic disk, and an optical disk.

Finally, it should be noted that the above are preferred embodiments of the present disclosure, and are only intended to describe the technical solution of the present disclosure but not to limit the protection scope of the present disclosure. Any modifications, equivalent replacements, improvements and the like made within the spirit and principle of the present disclosure all fall within the protection scope of the present disclosure.

**Claims**

1. A method for monitoring operating data of a boiler system based on a Bayesian network, wherein the method comprises:

   S1: establishing a boiler system state model according to association relationships between various components of a boiler system and different positions of the components;
   S2: collecting operating states of the components and of the components at the different positions by means of a sensor, so as to obtain a boiler system observation model;
   S3: obtaining a boiler system model by combining the boiler system state model and the boiler system observation model; and
   S4: according to the boiler system model, inferring missing observation data and determining whether the observation data is abnormal.

2. The method for monitoring operating data of a boiler system based on a Bayesian network according to claim 1, wherein
   overall state distribution of the boiler system state model in S1 is expressed by the formula as follows:

$$P(z_{1:n}) = P(z_1)P(z_2|z_1) \cdots P(z_n|z_{1:n-1})$$

   where $z_{1:n}$ is a collection of different components in the boiler system; and $z_n$ is the state of the $n^{th}$ component in the boiler system.

3. The method for monitoring operating data of a boiler system based on a Bayesian network according to claim 2, wherein
   in the boiler system state model, a relationship between the input $z_{n-1}$ and the output $z_n$ is:

$$z_n = F(z_{n-1}) + u$$

   where F is a function of the system state model; $u$ is noise of the system state model, which conforms to Gaussian distribution.

4.  The method for monitoring operating data of a boiler system based on a Bayesian network according to claim 3, wherein
    in the boiler system state model, conditional probability distribution between the input $z_{n-1}$ and the output $z_n$ is:

$$P(z_n|z_{n-1}) = N(F(z_{n-1}), \Sigma)$$

where $N(F(z_{n-1}), \Sigma)$ denotes Gaussian distribution.

5.  The method for monitoring operating data of a boiler system based on a Bayesian network according to claim 2, wherein
    the boiler system observation model in S2 is expressed as:

$$P(x|z) = N(H(z), \sigma^2)$$

where $P(x|z)$ is probability distribution of measurements under the state $z$; $x$ denotes an observed value of the sensor; $H$ is a function of the system observation model; and $N(H(z), \sigma^2)$ denotes Gaussian distribution.

6.  The method for monitoring operating data of a boiler system based on a Bayesian network according to claim 5, wherein
    the observed value of the sensor and the function of the system observation model satisfy the formula:

$$x = H(z) + \varepsilon$$

where $\varepsilon$ is noise of the observation model, which conforms to Gaussian distribution.

7.  The method for monitoring operating data of a boiler system based on a Bayesian network according to claim 5, wherein
    the boiler system model in S3 is expressed by the formula as follows:

$$P(z_{1:n}, x_{1:n}) = P(z_1) P(z_2|z_1) \cdots P(z_n|z_{1:n-1}) P(x_2|z_1) \cdots P(x_n|z_n)$$

where $P(z_{1:n}, x_{1:n})$ is joint probability distribution of states and measurements.

8.  An apparatus for monitoring operating data of a boiler based on a Bayesian network, wherein the apparatus comprises: a state module, an observation module, an integration module, and a monitoring module, wherein
    the state module is configured to establish a boiler system state model according to association relationships between various components of a boiler system and different positions of the components;
    the observation module is configured to collect operating states of the components and of the components at the different positions by means of a sensor, so as to obtain a boiler system observation model;
    the integration module is configured to obtain a boiler system model by combining the boiler system state model established by the state module and the boiler system observation model obtained by the observation module; and
    the monitoring module is configured to, according to the boiler system model, infer missing observation data and determine whether the observation data is abnormal.

9.  The apparatus for monitoring operating data of a boiler based on a Bayesian network according to claim 8, wherein overall state distribution of the boiler system state model established by the state module is expressed by the formula as follows:

$$P(z_{1:n}) = P(z_1)P(z_2|z_1) \cdots P(z_n|z_{1:n-1})$$

where $z_{1:n}$ is a collection of different components in the boiler system; and $z_n$ is the state of the $n^{th}$ component in the boiler system;

in the boiler system state model, a relationship between the input $z_{n-1}$ and the output $z_n$ is:

$$z_n = F(z_{n-1}) + u$$

where F is a function of the system state model; $u$ is noise of the system state model, which conforms to Gaussian distribution;

in the boiler system state model, conditional probability distribution between the input $z_{n-1}$ and the output $z_n$ is:

$$P(z_n|z_{n-1}) = N(F(z_{n-1}), \Sigma)$$

where $N(F(z_{n-1}), \Sigma)$ denotes Gaussian distribution;

the boiler system observation model obtained by the observation module is expressed as:

$$P(x|z) = N(H(z), \sigma^2)$$

where P($x|z$) is probability distribution of measurements under the state $z$; $x$ denotes an observed value of the sensor; $H$ is a function of the system observation model; and N($H(z)$, $\sigma^2$) denotes Gaussian distribution; and the observed value of the sensor and the function of the system observation model satisfy the formula:

$$x = H(z) + \varepsilon$$

where $\varepsilon$ is noise of the observation model, which conforms to Gaussian distribution.

10. The apparatus for monitoring operating data of a boiler based on a Bayesian network according to claim 9, wherein the boiler system model obtained by the integration module is expressed by the formula as follows:

$$P(z_{1:n}, x_{1:n}) = P(z_1) \, P(z_2|z_1) \cdots P(z_n|z_{1:n-1}) P(x_2|z_1) \cdots P(x_n|z_n)$$

where P($z_{1:n}$, $x_{1:n}$) is joint probability distribution of states and measurements.

| Establish a boiler system state model according to association relationships between various components of a boiler system and different positions of the components | S1 |

| Collect operating states of the components and of the components at the different positions by means of a sensor, so as to obtain a boiler system observation model | S2 |

| Obtain a boiler system model by combining the boiler system state model and the boiler system observation model | S3 |

| According to the boiler system model, infer missing observation data and determine whether the observation data is abnormal | S4 |

FIG. 1

Equipment state

Sensor observation

Missing observation, partial observation

Anomaly observation

FIG. 2

| State module | Observation module |
|---|---|

| Integration module |
|---|

| Monitoring module |
|---|

FIG. 3

<div align="center">

**INTERNATIONAL SEARCH REPORT**

</div>

| International application No. |
| --- |
| **PCT/CN2019/107944** |

**A.    CLASSIFICATION OF SUBJECT MATTER**

G06N 7/00(2006.01)i

According to International Patent Classification (IPC) or to both national classification and IPC

**B.    FIELDS SEARCHED**

Minimum documentation searched (classification system followed by classification symbols)

G06N

Documentation searched other than minimum documentation to the extent that such documents are included in the fields searched

Electronic data base consulted during the international search (name of data base and, where practicable, search terms used)

WPI, EPODOC, CNPAT, CNKI: 锅炉, 贝叶斯, 模型, 数据, 样本, 信息, 丢失, 缺失, 异常, 传感器, 观测, 检测, 采样, boiler, bayes, model, sens+, data, information, stylebook, lose, deletion, abnormity, observ+, detect+, sample

**C.    DOCUMENTS CONSIDERED TO BE RELEVANT**

| Category* | Citation of document, with indication, where appropriate, of the relevant passages | Relevant to claim No. |
| --- | --- | --- |
| PX | CN 109523027 A (ENNEW DIGITAL TECHNOLOGY CO., LTD.) 26 March 2019 (2019-03-26) claims 1-10 | 1-10 |
| Y | CN 105718717 A (YE, Xiang et al.) 29 June 2016 (2016-06-29) description, paragraphs [0002]-[0108] | 1, 2, 8 |
| Y | CN 104865956 A (CHONGQING UNIVERSITY) 26 August 2015 (2015-08-26) description, paragraphs [0002]-[0047] | 1, 2, 8 |
| A | CN 108596229 A (BEIJING HUADIAN SMART TECHNOLOGY INDUSTRY CO., LTD.) 28 September 2018 (2018-09-28) entire document | 1-10 |
| A | CN 101436057 A (ZHEJIANG UNIVERSITY) 20 May 2009 (2009-05-20) entire document | 1-10 |
| A | CN 108663980 A (HARBIN BOILER COMPANY LIMITED) 16 October 2018 (2018-10-16) entire document | 1-10 |
| A | US 4027145 A (MCDONALD, John P.) 31 May 1977 (1977-05-31) entire document | 1-10 |

☐ Further documents are listed in the continuation of Box C.          ☑ See patent family annex.

| | |
| --- | --- |
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| **11 December 2019** | **24 December 2019** |

| Name and mailing address of the ISA/CN | Authorized officer |
| --- | --- |
| **China National Intellectual Property Administration (ISA/CN)**<br>**No. 6, Xitucheng Road, Jimenqiao Haidian District, Beijing 100088**<br>**China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2019/107944**

| Patent document cited in search report | | | Publication date (day/month/year) | Patent family member(s) | | | Publication date (day/month/year) |
|---|---|---|---|---|---|---|---|
| CN | 109523027 | A | 26 March 2019 | None | | | |
| CN | 105718717 | A | 29 June 2016 | None | | | |
| CN | 104865956 | A | 26 August 2015 | CN | 104865956 | B | 07 July 2017 |
| CN | 108596229 | A | 28 September 2018 | None | | | |
| CN | 101436057 | A | 20 May 2009 | None | | | |
| CN | 108663980 | A | 16 October 2018 | None | | | |
| US | 4027145 | A | 31 May 1977 | None | | | |

Form PCT/ISA/210 (patent family annex) (January 2015)

16